# EUROPÄISCHE PATENTSCHRIFT

(11) **EP 3 847 677 B1**
(45) Veröffentlichungstag und Bekanntmachung des Hinweises auf die Patenterteilung: **30.09.2026**
(21) Anmeldenummer: 19753037.1
(22) Anmeldetag: 09.08.2019
(51) Int. Cl.: H01C 7/00, H01C 1/142, H01C 1/144, H01C 1/084, B22F 3/22, G01R 1/20, H01C 17/28, H01C 17/065, H01C 7/22, H01C 7/06

(54) **HERSTELLUNGSVERFAHREN FÜR EIN ELEKTRISCHES WIDERSTANDSELEMENT UND ENTSPRECHENDES WIDERSTANDSELEMENT**
PRODUCTION METHOD FOR AN ELECTRICAL RESISTANCE ELEMENT AND CORRESPONDING RESISTANCE ELEMENT
PROCÉDÉ DE FABRICATION POUR UN ÉLÉMENT DE RÉSISTANCE ÉLECTRIQUE ET ÉLÉMENT DE RÉSISTANCE CORRESPONDANT

(30) Priorität: 07.09.2018 DE 102018121902
(43) Veröffentlichungstag der Anmeldung: 14.07.2021
(73) Patentinhaber: Isabellenhütte Heusler GmbH & Co. KG, 35683 Dillenburg (DE); Schunk Sintermetalltechnik GmbH, 06502 Thale (DE)
(72) Erfinder: MARIEN, Jan, 35745 Herborn (DE); HARTMANN, Jens, 35713 Eschenburg (DE); SCHMIDT, Petra, 35713 Eschenburg (DE); BAUM, Andreas, 35080 Bad Endbach (DE); PRINZ, Phillip, 35641 Schöffengrund (DE); BURK, Steffen, 35075 Gladenbach (DE); LANGER, Ingolf, 06484 Quedlinburg (DE); WITT, Alexander, 06493 Ballenstedt (DE); ZIESCHE, Jörg, 06502 Thale (DE); MÜLLER, Sieglinde, 06502 Thale (DE)
(74) Vertreter: v. Bezold & Partner Patentanwälte - PartG mbB
(86) Internationale Anmeldenummer: PCT/EP2019/071395
(87) Internationale Veröffentlichungsnummer: WO 2020/048726

(56) Entgegenhaltungen:
- EP-A1- 3 309 800
- WO-A1-2004/039522
- DE-A1- 102005 059 561
- DE-C1- 4 339 551
- JP-A- 2014 103 076
- KR-A- 20160 101 251
- US-A1- 2006 158 304
- US-A1- 2009 195 348
- US-A1- 2012 258 008

## Beschreibung

Die Erfindung betrifft ein Herstellungsverfahren für ein elektrisches Widerstandselement, insbesondere für einen Strommesswiderstand. Weiterhin betrifft die Erfindung einen Widerstand, der mit dem erfindungsgemäßen Herstellungsverfahren hergestellt wurde.

Aus EP 0 605 800 A1 ist ein Herstellungsverfahren für einen Strommesswiderstand bekannt, wie er auch in Fig. 1 dargestellt ist. Dabei wird ein Materialband einer Widerstandslegierung (z.B. Manganin^{®}) entlang seiner beiden Längskanten mit jeweils einem Materialband aus einem Leitermaterial (z.B. Kupfer) verschweißt, so dass ein Verbundmaterialband ("Tri-Band") entsteht. Anschließend werden dann von dem Verbundmaterialband die einzelnen Strommesswiderstände abgetrennt, was beispielsweise in einem Stanz-Biege-Automaten geschehen kann. Dieses bekannte Herstellungsverfahren ermöglicht eine kostengünstige Massenherstellung von Strommesswiderständen.

Nachteilig an diesem bekannten Herstellungsverfahren ist jedoch die eingeschränkte Freiheit bei der Formgestaltung des Strommesswiderstands, da der Strommesswiderstand aus dem flachen Verbundmaterialband abgetrennt wird, so dass Oberseite und Unterseite des fertigen Strommesswiderstands parallel sind.

Das Dokument EP 3 309 800 A1 offenbart einen Schichtaufbau aufweisend ein Substrat mit einer Glas- oder Keramikoberfläche, eine Schicht A, die die Glas- oder Keramikoberfläche des Substrats wenigstens teilweise bedeckt, wobei Schicht A ein Glas aufweist, in dem wenigstens zwei voneinander verschiedene Elemente als Oxide enthalten sind und eine Schicht B, die Schicht A wenigstens teilweise bedeckt. Schicht B weist eine Widerstandslegierung mit einem Temperaturkoeffizienten des elektrischen Widerstands weniger als 150 ppm/K auf.

Das Dokument KR 2016 0101251 A beschreibt einen Messwiderstand und ein korrespondierendes Herstellungsverfahren. Der Messwiderstand umfasst eine Batterieanschluss-Kombinationseinheit, die aus Aluminium oder einer Aluminiumlegierung gebildet und mit einer Batterie verbunden ist.

Der Messwiderstand umfasst ferner ein erstes und zweites Anschlussteil aus Aluminium oder einer Aluminiumlegierung zwischen Verbindungskabeln aus Aluminium oder einer Aluminiumlegierung, die mit einer elektronischen Steuereinheit (ECU) verbunden sind, und einen Widerstandsteil, der zwischen erstem und zweitem Anschlussteil angeordnet und aus Mangan oder Manganlegierung gebildet ist.

Der Erfindung liegt deshalb die Aufgabe zugrunde, den Gestaltungsspielraum hinsichtlich der Formgebung eines Strommesswiderstands zu erhöhen.

Diese Aufgabe wird durch ein erfindungsgemäßes Herstellungsverfahren gemäß Anspruch 1 bzw. durch einen entsprechend hergestellten Widerstand gelöst.

Das erfindungsgemäße Herstellungsverfahren sieht zunächst vor, dass eine Widerstandslegierung in Pulverform bereitgestellt wird, wobei die pulverförmige Widerstandslegierung zunächst keinerlei Beschränkungen hinsichtlich der Form unterliegt. Aus dem pulverförmigen Widerstandsmaterial wird dann im Rahmen des erfindungsgemäßen Herstellungsverfahrens das Widerstandselement geformt. Das erfindungsgemäße Herstellungsverfahren führt also vorteilhaft zu keinerlei Beschränkungen hinsichtlich der Form des fertigen Widerstandselements.

Hierbei ist zu erwähnen, dass sich das erfindungsgemäße Herstellungsverfahren nicht nur zur Herstellung von niederohmigen Strommesswiderständen eignet, die zur Strommessung gemäß der bekannten Vierleitertechnik verwendet werden können. Vielmehr eignet sich das erfindungsgemäße Herstellungsverfahren allgemein zur Herstellung von elektrischen Widerstandselementen.

Gemäß der Erfindung ist vorgesehen, dass zum Formen des Widerstandselements ein Mehrkomponenten-Metallpulverspritzgießverfahren eingesetzt wird, wobei das Widerstandselement aus der pulverförmigen Widerstandslegierung mit zwei Anschlussteilen aus einem pulverförmigen Leitermaterial (z.B. Kupfer, Kupferlegierung) zusammengefügt wird.

Im Rahmen des erfindungsgemäßen Herstellungsverfahrens ist vorzugsweise vorgesehen, dass die pulverförmige Widerstandslegierung (z.B. Manganin^{®}) und/oder das pulverförmige Leitermaterial (z.B. Kupfer, Kupferlegierung) vor dem Formen mit einem Binder zu einem sogenannten Feedstock gemischt wird. Bei dem Binder handelt es sich vorzugsweise um einen organischen Binder oder um ein Gemisch von mehreren, vorzugsweise organischen Komponenten. Beispielsweise kann der Feedstock 50-80 Gewichtsprozent der Widerstandslegierung und 20-50% der organischen Komponenten enthalten.

Nach dem Formen wird das Grünteil dann vorzugsweise zu einem sogenannten Braunteil entbindert, wobei der Binder mindestens teilweise aus dem Grünteil entfernt wird.

Das Braunteil kann dann zu dem fertigen Widerstand gesintert werden.

Anschließend ist eine Nachbearbeitung des Widerstandselements möglich, wobei beispielsweise der Widerstandswert des Widerstandselements durch Fräsen oder Stanzen korrigiert bzw. justiert werden kann.

Die Erfindung ist hinsichtlich des Binders nicht auf bestimmte Materialien oder Materialzusammensetzungen beschränkt. Beispielsweise eignen sich folgende Materialien im Rahmen des erfindungsgemäßen Herstellungsverfahrens als Binder: Polyamid, Polyoxymethylen, Polycarbonat, Styrol-Acrylnitril-Copolymerisat, Polyimid, natürliches Wachs und Öl, Duroplast, Cyanate, Polypropylene, Polyacetate, Polyethylene, Ethylen-Vinyl-Acetate, Polyvinyl-Alkohole, Polyvinyl-Chloride, Polystyrol, Polymethyl-Methacrylate, Anilin, Wasser, Mineralöl, Agar, Glycerin, Polyvinyl-Butyryl, Polybutyl-Methacrylat, Cellulose, Ölsäure, Phthalat, Paraffin, Wachs, insbesondere Carnauba-Wachs, Ammonium, Polyacrylat, Diglycerid-Stearate und -Oleate Glyceryl-Monostearate, Isopropyl-Titanate, Lithium-Stearate, Monoglyceride, Formaldehyde, Octyl-Säure-Phosphate, Olefin-Sulfonate, Phosphatester, Stearinsäure, Zinkstearate.

Weiterhin ist zu erwähnen, dass der Binder beispielsweise auch folgende Bestandteile enthalten kann:
a) 10-50 Gewichtsprozent Polyamid,
b) 40-80 Gewichtsprozent Fettalkohol und
c) 2-20 Gewichtsprozent einer organischen Säure.

Ferner besteht die Möglichkeit, dass der Binder folgende Bestandteile enthält:
a) 50-96 Gewichtsprozent eines oder mehrerer Polyoxymethylen-Homopolymerisate oder Polyoxymethylen-Copolymerisate,
b) 2-35 Gewichtsprozent eines oder mehrerer Polyolefine und
c) 2-40 Gewichtsprozent Poly-1,3-dioxepan oder Poly-1,3-dioxolan oder deren Mischungen.

Auch hinsichtlich der pulverförmigen Widerstandslegierung ist das erfindungsgemäße Herstellungsverfahren nicht auf bestimmte Widerstandslegierungen beschränkt. Vorzugsweise enthält die pulverförmige Widerstandslegierung jedoch als Hauptbestandteil Kupfer oder Nickel.

Beispielsweise kann die pulverförmige Widerstandslegierung folgende Legierungsbestandteile enthalten:
a) 0,01-95,0 Gewichtsprozent Kupfer,
b) 0,01-80,0 Gewichtsprozent Nickel,
c) 0,01-30,0 Gewichtsprozent Mangan,
d) 0,001-5,0 Gewichtsprozent Zinn,
e) 0,001-22,0 Gewichtsprozent Chrom,
f) 0,001-5,0 Gewichtsprozent Aluminium,
g) 0,001-2,0 Gewichtsprozent Silizium,
h) 0,001-1,5 Gewichtsprozent Eisen, und/oder
i) höchstens 1,0 Gewichtsprozent sonstige Legierungsbestandteile.

Alternativ besteht die Möglichkeit, dass die pulverförmige Widerstandslegierung folgende Legierungsbestandteile enthält:
a) 50,5,0-55,0 Gewichtsprozent Kupfer,
b) 42,0-46,0 Gewichtsprozent Nickel,
c) 0,5-2,0 Gewichtsprozent Mangan, und
d) höchstens 1,5 Gewichtsprozent sonstige Legierungsbestandteile.

Ein weiteres Ausführungsbeispiel einer erfindungsgemäßen pulverförmigen Widerstandslegierung enthält folgende Legierungsbestandteile:
a) 81,0-89,6 Gewichtsprozent Kupfer,
b) 10,0-14,0 Gewichtsprozent Mangan,
c) 0,4-4,0 Gewichtsprozent Nickel, und
d) höchstens 1,0 Gewichtsprozent sonstige Legierungsbestandteile.

In einem anderen Ausführungsbeispiel enthält die pulverförmige Widerstandslegierung folgende Legierungsbestandteile:
a) 60,0-69,0 Gewichtsprozent Kupfer,
b) 23,0-27,0 Gewichtsprozent Mangan,
c) 8,0-12,0 Gewichtsprozent Nickel, und
d) höchstens 1,0 Gewichtsprozent sonstige Legierungsbestandteile.

Noch ein weiteres Ausführungsbeispiel der erfindungsgemäßen Widerstandslegierung enthält folgende Legierungsbestandteile:
a) 88,0-92,5 Gewichtsprozent Kupfer,
b) 6,0-8,0 Gewichtsprozent Mangan,
c) 1,5-3,0 Gewichtsprozent Zinn, und
d) höchstens 1,0 Gewichtsprozent sonstige Legierungsbestandteile.

Schließlich besteht im Rahmen der Erfindung die Möglichkeit, dass die pulverförmige Widerstandslegierung folgende Legierungsbestandteile enthält:
a) 62,0-81,4 Gewichtsprozent Nickel,
b) 16,0-22,0 Gewichtsprozent Chrom,
c) 2,0-4,0 Gewichtsprozent Aluminium,
d) 0,4-2,0 Gewichtsprozent Silizium,
e) 0,1-5,0 Gewichtsprozent Mangan,
f) 0,02-3,0 Gewichtsprozent Kupfer,
g) 0,1-1,0 Gewichtsprozent Eisen, und
h) höchstens 1,0 Gewichtsprozent sonstige Legierungsbestandteile.

Das erfindungsgemäße Herstellungsverfahren ermöglicht es vorteilhaft, dass das fertige Widerstandselement einen temperaturstabilen elektrischen Widerstandswert aufweist, wobei der Widerstandswert einen Temperaturkoeffizienten von betragsmäßig weniger als 50ppm/K aufweist, bezogen auf einen Temperaturbereich von +20°C bis +60°C.

Darüber hinaus ermöglicht das erfindungsgemäße Herstellungsverfahren die Herstellung eines elektrischen Widerstands mit einem Widerstandswert mit einer guten Langzeitkonstanz, d.h. mit einer Langzeitdrift von weniger als 10% gemäß AEC-Q200.

Die verwendete Widerstandslegierung ist vorzugsweise niederohmig und weist einen spezifischen elektrischen Widerstand von weniger als 20·10⁻⁷ Ωm, 10·10⁻⁷ Ωm, 5·10⁻⁷ Ωm oder 3·10⁻⁷ Ωm auf.

Das Leitermaterial der Anschlussteile ist dagegen vorzugsweise noch niederohmiger als die Widerstandslegierung und weist vorzugsweise einen spezifischen elektrischen Widerstand von weniger als 5·10⁻⁷ Ωm, 2·10⁻⁷ Ωm, 1·10⁻⁷ Ωm, 5·10⁻⁸ Ωm oder 2·10⁻⁸ Ωm auf.

Das Leitermaterial der Anschlussteile hat also vorzugsweise einen kleineren spezifischen elektrischen Widerstand als die Widerstandslegierung des Widerstandselements.

Ferner ist zu erwähnen, dass die Widerstandslegierung in der thermoelektrischen Spannungsreihe gegenüber Kupfer vorzugsweise eine Thermospannung von weniger als ±5 mV/100 K, ±0,5 mV/100 K, ±0,3 mV/100 K oder ±0,2 mV/100 K aufweist.

Weiterhin besteht im Rahmen des erfindungsgemäßen Herstellungsverfahrens die Möglichkeit, dass verschiedene Widerstandsschichten in Parallelschluss oder in Reihenschluss miteinander kombiniert werden, um eine Optimierung der elektrischen Eigenschaften zu erreichen. Der elektrische Strom kann dann parallel durch die verschiedenen Widerstandsschichten bzw. nacheinander in Reihe durch die verschiedenen Widerstandsschichten fließen.

Darüber hinaus ermöglicht das erfindungsgemäße Herstellungsverfahren auch die Kombinierung von verschiedenen Werkstoffen zu der Widerstandsschicht in Parallelschluss und/oder Reihenschluss, um eine Optimierung der mechanischen Eigenschaften zu erreichen.

Weiterhin können im Rahmen des erfindungsgemäßen Herstellungsverfahrens auch verschiedene Werkstoffe zu der Widerstandsschicht kombiniert werden (parallel oder in Reihe), um die thermischen Eigenschaften zu optimieren.

Weiterhin ist zu erwähnen, dass das erfindungsgemäße Herstellungsverfahren die Möglichkeit bietet, Kühlkörper (z.B. Kühlrippen) an das Widerstandselement anzuformen.

In einem Ausführungsbeispiel der Erfindung ist der fertige Widerstand ein Koaxialwiderstand, bei dem der elektrische Strom in dem Koaxialwiderstand in entgegengesetzten Richtungen koaxial fließt, was an sich aus dem Stand der Technik bekannt ist.

Die Erfindung beansprucht jedoch nicht nur Schutz für das vorstehend beschriebene erfindungsgemäße Herstellungsverfahren. Vielmehr beansprucht die Erfindung auch Schutz für einen fertigen Widerstand, der in der vorstehend beschriebenen Weise gemäß dem erfindungsgemäßen Herstellungsverfahren hergestellt wurde.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: eine Perspektivansicht eines herkömmlichen Strommesswiderstands, der in herkömmlicher Weise hergestellt wurde,
- Figur 2: eine Aufsicht auf ein Widerstandselement, das mit dem erfindungsgemäßen Herstellungsverfahren hergestellt wurde,
- Figur 3: ein Flussdiagramm zur Verdeutlichung des erfindungsgemäßen Herstellungsverfahrens durch Zweikomponenten-Metallspritzgießen,
- Figur 4: ein anderes Flussdiagramm zur Verdeutlichung eines nicht erfindungsgemäßen Herstellungsverfahrens mittels Metallspritzgießen,
- Fig. 5A und 5B: verschiedene Perspektivansichten eines Koaxialwiderstands, der mit dem erfindungsgemäßen Herstellungsverfahren hergestellt wurde,
- Fig. 6A und 6B: verschiedene Perspektivansichten eines mehrfach gebogenen Strommesswiderstands, sowie
- Fig. 7A und 7B: verschiedene Perspektivansichten eines erfindungsgemäßen Widerstands mit angeformten Kühlrippen.

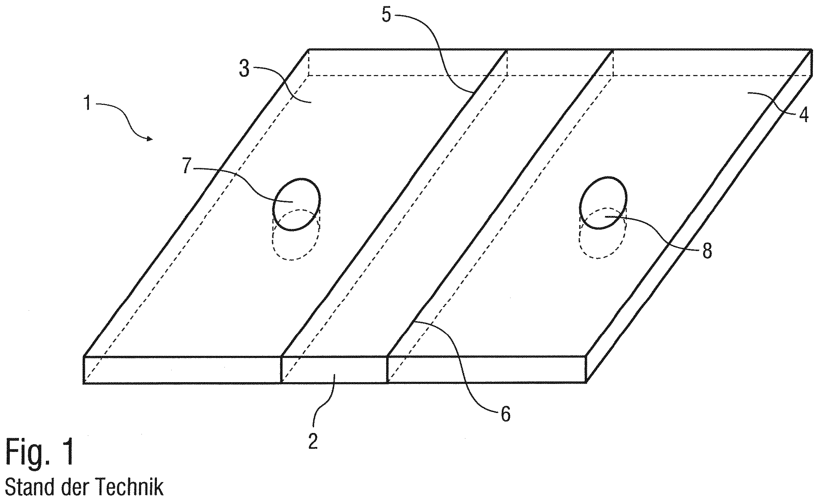

Figur 1 zeigt eine Perspektivansicht eines herkömmlichen Strommesswiderstands 1, der zur Strommessung gemäß der bekannten Vierleitertechnik dient und aus einem Verbundmaterialband abgetrennt ist, wie es in EP 0 605 800 A1 beschrieben ist.

Der Strommesswiderstand 1 besteht im Wesentlichen aus einem Widerstandselement 2 aus einer Widerstandslegierung (z.B. Manganin^{®}) und zwei Anschlussteilen 3, 4 aus einem Leitermaterial (z.B. Kupfer), wobei das Widerstandselement 2 entlang seiner Längskanten durch zwei Schweißnähte 5, 6 mit den Anschlussteilen 3 bzw. 4 verbunden ist.

In den beiden Anschlussteilen 3, 4 befinden sich hierbei Bohrungen 7, 8, die als Anschlusselemente dienen, um die elektrische Kontaktierung zu erleichtern.

Nachteilig an diesem bekannten Strommesswiderstand 1 ist die Tatsache, dass die Formgebung durch den Querschnitt des zugrunde liegenden Verbundmaterialbands beschränkt ist, so dass nicht beliebige Formen des Strommesswiderstands möglich sind.

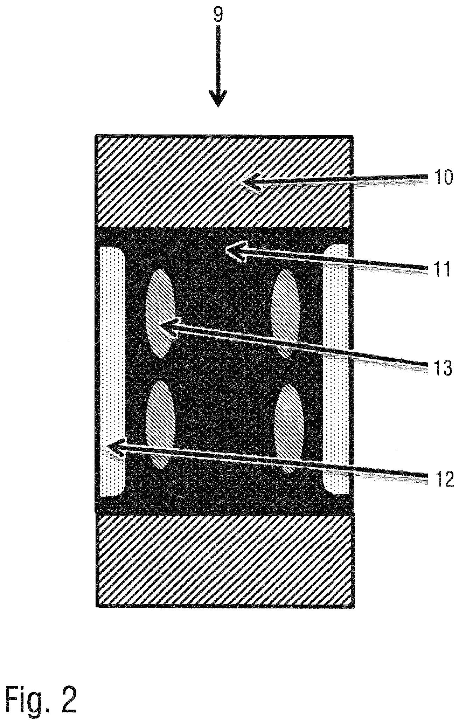

Figur 2 zeigt eine Aufsicht auf ein erfindungsgemäßes Widerstandselement 9, das durch Metallspritzgießen (MIM: Metal Injection Moulding) hergestellt wurde und deshalb vielfältige Formen annehmen kann.

Aus der Zeichnung ist ersichtlich, dass das Widerstandselement 9 Fügeflächen 10 aufweist, um das Widerstandselement 9 mit Anschlussteilen verbinden zu können.

Weiterhin zeigt die Zeichnung ein gesintertes Widerstandsmaterial 11, das verschiedene Formen annehmen kann.

Seitlich an dem Widerstandselement 9 können sich Bereiche 12 für die Anpassung des Widerstandswertes befinden.

Darüber hinaus zeigt die Zeichnung elliptische Bereiche 13 zur Kontaktierung von Messanschlüssen.

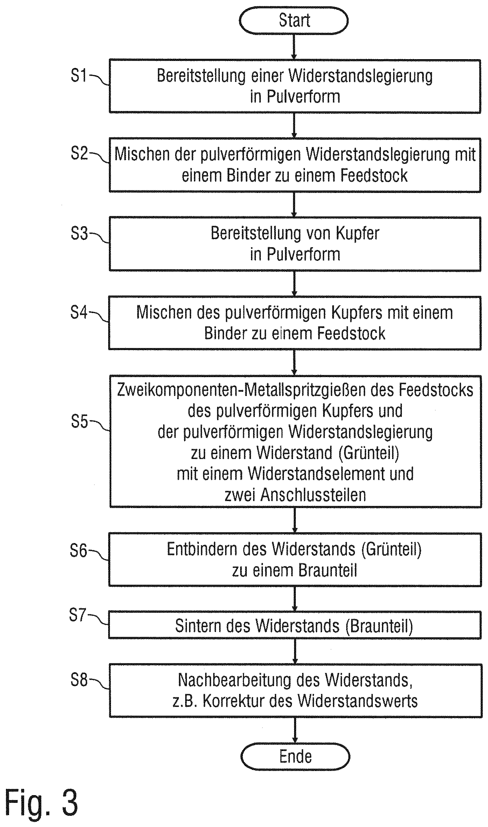

Im Folgenden wird nun das Flussdiagramm gemäß Figur 3 erläutert, das ein Ausführungsbeispiel des erfindungsgemäßen Herstellungsverfahrens erläutert.

In einem ersten Schritt S1 wird zunächst eine Widerstandslegierung in Pulverform bereitgestellt.

In einem zweiten Schritt S2 wird die pulverförmige Widerstandslegierung dann mit einem Binder zu einem sogenannten Feedstock gemischt.

In einem Schritt S3 wird Kupfer für die Anschlussteile in Pulverform bereitgestellt.

Das pulverförmige Kupfer wird dann ebenfalls in einem Schritt S4 mit einem Binder zu einem Feedstock gemischt.

In einem weiteren Schritt S5 erfolgt dann ein Zweikomponenten-Metallspritzgießen des Feedstocks des pulverförmigen Kupfers und des Feedstocks der pulverförmigen Widerstandslegierung zu einem Widerstand (Grünteil) mit einem Widerstandselement und zwei Anschlussteilen.

In einem nächsten Schritt S6 wird der Widerstand (Grünteil) dann entbindert, d.h. es wird der Binder wenigstens teilweise entfernt, so dass ein sogenanntes Braunteil entsteht.

In einem weiteren Schritt S7 wird dann das Braunteil gesintert.

Schließlich kann in einem Schritt S8 noch eine Nachbearbeitung des Widerstands erfolgen, z.B. zur Korrektur des Widerstandswerts.

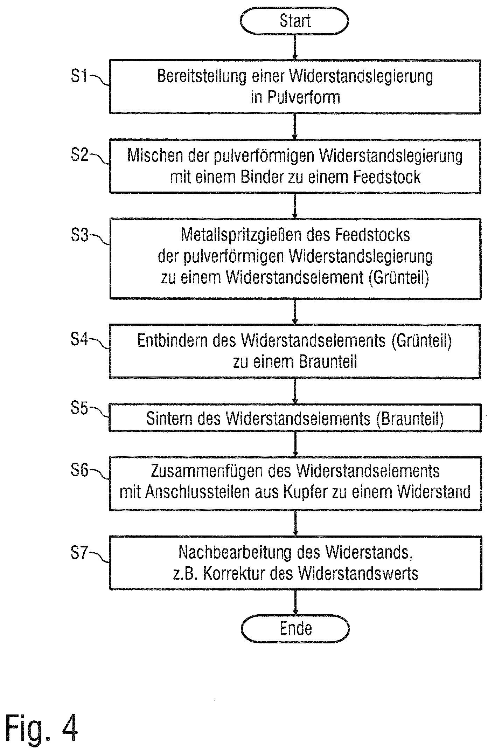

Im Folgenden wird nun das Flussdiagramm gemäß Figur 4 erläutert, das ein nicht erfindungsgemäßes Herstellungsverfahren erläutert.

Hierbei erfolgt in einem ersten Schritt S1 wieder eine Bereitstellung einer Widerstandslegierung in Pulverform.

In einem zweiten Schritt S2 wird die pulverförmige Widerstandslegierung dann mit einem Binder zu einem Feedstock gemischt.

In einem weiteren Schritt S3 erfolgt dann ein Metallspritzgießen des Feedstocks der pulverförmigen Widerstandslegierung zu einem Widerstandselement (Grünteil).

Im nächsten Schritt S4 wird das Grünteil dann zu einem Braunteil entbindert, d.h. der zuvor zugeführte Binder wird mindestens teilweise wieder entfernt.

Im nächsten Schritt S5 wird das Braunteil des Widerstandselements dann gesintert.

In einem weiteren Schritt S6 wird das Widerstandselement dann mit den Anschlussteilen aus Kupfer zu einem Widerstand zusammengefügt.

Schließlich kann in einem Schritt S7 noch eine Nachbearbeitung des Widerstands erfolgen, z.B. zur Korrektur des Widerstandswerts.

Das Ausführungsbeispiel gemäß Figur 4 unterscheidet sich also von dem Ausführungsbeispiel gemäß Figur 3 im Wesentlichen dadurch, dass bei dem Ausführungsbeispiel gemäß Figur 4 die Anschlussteile nach dem Metallspritzgießen angebracht werden, während die Anschlussteile bei dem Ausführungsbeispiel gemäß Figur 3 im Rahmen des Zweikomponenten-Metallspritzgießens angeformt werden.

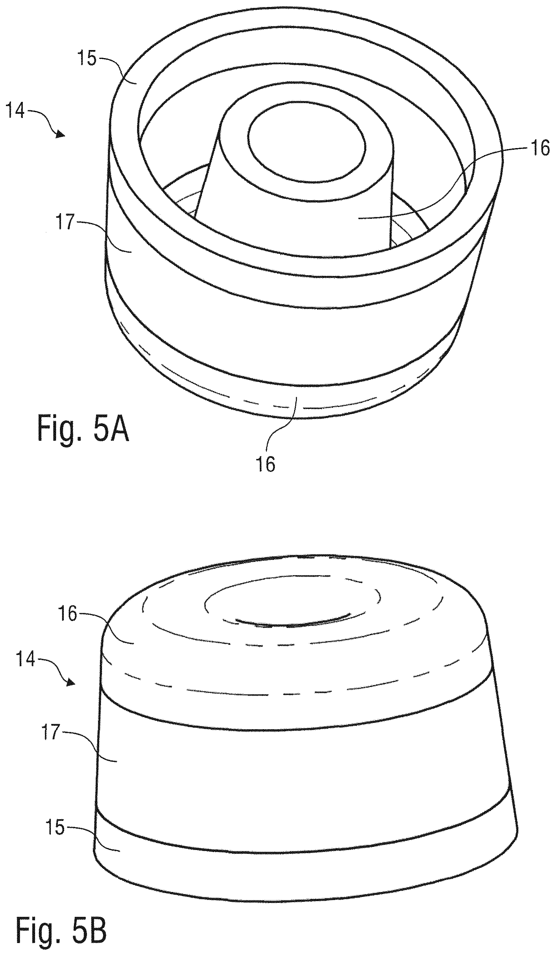

Im Folgenden wird nun das Ausführungsbeispiel gemäß Figur 5A und 5B beschrieben. So zeigen diese Zeichnungen einen erfindungsgemäßen Koaxialwiderstand 14 mit zwei Anschlussteilen 15, 16 aus einem Leitermaterial (z.B. Kupfer) und einem dazwischen eingesetzten Widerstandselement 17 aus einer Widerstandslegierung.

Das erfindungsgemäße Herstellungsverfahren ermöglicht hierbei einen großen Gestaltungsspielraum hinsichtlich der äußeren Form des Koaxialwiderstands 14, der komplexe Wölbungen aufweisen kann.

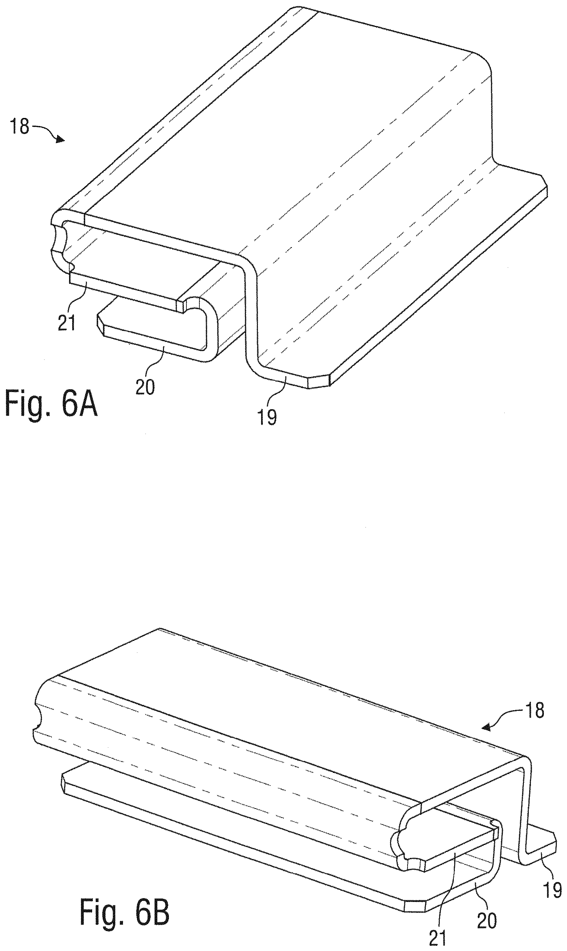

Im Folgenden wird nun das Ausführungsbeispiel gemäß den Figuren 6A und 6B beschrieben. So zeigen die Zeichnungen verschiedene Perspektivansichten eines erfindungsgemäßen Strommesswiderstands 18 mit Anschlussteilen 19, 20 aus einem Leitermaterial (z.B. Kupfer) und einem dazwischen eingesetzten Widerstandselement 21 aus einer Widerstandslegierung.

Das erfindungsgemäße Herstellungsverfahren ermöglicht hierbei komplexe Biegungen des Strommesswiderstands 18.

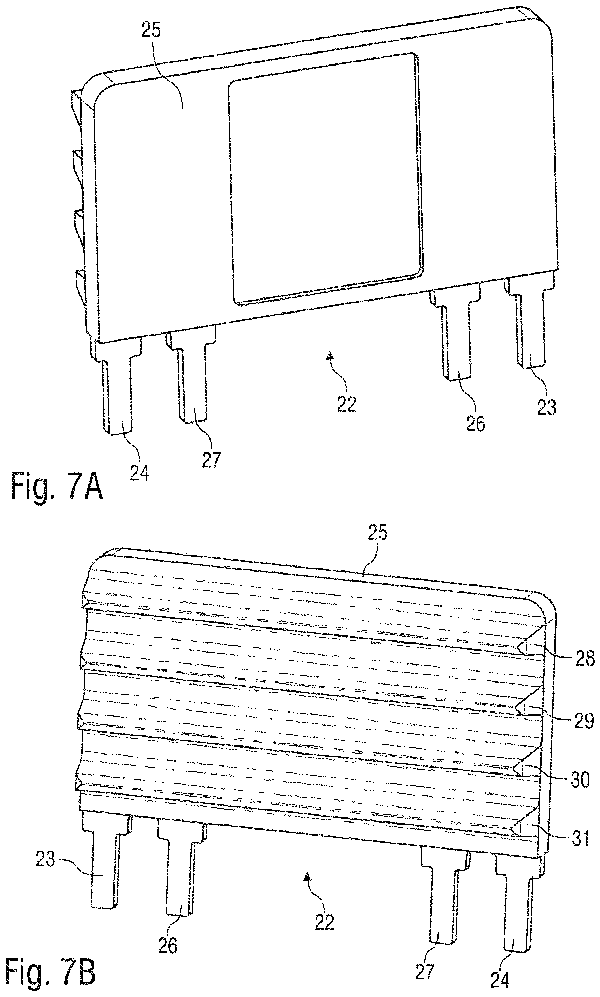

Im Folgenden wird nun schließlich das Ausführungsbeispiel gemäß den Figuren 7A und 7B beschrieben.

So zeigen die Zeichnungen einen Strommesswiderstand 22, der entsprechend dem erfindungsgemäßen Herstellungsverfahren hergestellt wurde und zwei Anschlussteile 23, 24 sowie ein Widerstandselement 25 aufweist.

Darüber hinaus zeigen die Zeichnungen noch zwei Spannungsmesskontakte 26, 27 zur Messung der entlang dem Widerstandselement 25 abfallenden Spannung.

Schließlich zeigen die Zeichnungen noch Kühlrippen 28-31, die an das Widerstandselement 25 angeformt sind und im Betrieb Verlustwärme abführen.

### Bezugszeichenliste:

- 1: Strommesswiderstand
- 2: Widerstandselement
- 3, 4: Anschlussteile
- 5, 6: Schweißnähte
- 7, 8: Bohrungen
- 9: Widerstandselement
- 10: Fügeflächen
- 11: Widerstandsmaterial
- 12: Bereiche zur Anpassung des Widerstandswerts
- 13: Elliptische Bereiche zur Kontaktierung von Messanschlüssen
- 14: Koaxialwiderstand
- 15, 16: Anschlussteile
- 17: Widerstandselement
- 18: Strommesswiderstand
- 19, 20: Anschlussteile
- 21: Widerstandselement
- 22: Strommesswiderstand
- 23, 24: Anschlussteile
- 25: Widerstandselement
- 26, 27: Spannungsmesskontakte
- 28-31: Kühlrippen

## Patentansprüche

1. Herstellungsverfahren für einen elektrischen Widerstand (14; 18; 22) mit einem elektrischen Widerstandselement (9; 17; 21; 25) und mehreren Anschlussteilen (15, 16; 19, 20; 23, 24, 26, 27), insbesondere für einen Strommesswiderstand, mit folgenden Schritten:
a) Bereitstellung einer Widerstandslegierung in Pulverform, und
b) Formen des Widerstandselements (9; 17; 21; 25) aus der pulverförmigen Widerstandslegierung,
**dadurch gekennzeichnet,**
c) **dass** zum Formen des Widerstandselements (9; 17; 21; 25) ein Mehrkomponenten-Metallpulverspritzgießen eingesetzt wird, wobei folgende Komponenten des Widerstands (14; 18; 22) zu einem Grünteil zusammengefügt werden:
c1) das Widerstandselement (9; 17; 21; 25) aus der pulverförmigen Widerstandslegierung, und
c2) die Anschlussteile (15, 16; 19, 20; 23, 24, 26, 27) aus einem pulverförmigen Leitermaterial, insbesondere aus Kupfer oder einer Kupferlegierung.

2. Herstellungsverfahren nach Anspruch 1, **gekennzeichnet durch** folgende Schritte:
a) Mischen der pulverförmigen Widerstandslegierung und des pulverförmigen Leitermaterials mit einem Binder zu jeweils einem Feedstock vor dem Formen, insbesondere mit einem organischen Binder, insbesondere mit einem Gemisch von weiteren, insbesondere organischen Komponenten, wobei der Feedstock der Widerstandslegierung vorzugsweise folgende Bestandteile enthält:
a1) 50-80 Gewichtsprozent der Widerstandslegierung und
a2) 20-50 Gewichtsprozent der organischen Komponenten, und
b) Entbindern des Grünteils zu einem Braunteil nach dem Formen, wobei der Binder mindestens teilweise aus dem Grünteil entfernt wird, und
c) Sintern des Braunteils zu dem fertigen Widerstand (14; 18; 22), und
d) Nachbearbeiten des Widerstandselements (9; 17; 21; 25) insbesondere Korrektur des Widerstandswerts durch Fräsen oder Stanzen.

3. Herstellungsverfahren nach Anspruch 2, **dadurch gekennzeichnet, dass** der Binder mindestens eines der folgenden Materialien enthält:
a) Polyamid,
b) Polyoxymethylen,
c) Polycarbonat,
d) Styrol-Acrylnitril-Copolymerisat,
e) Polyimid,
f) natürliches Wachs und Öl,
g) Duroplast,
h) Cyanate,
i) Polypropylene,
j) Polyacetate,
k) Polyäthylene,
l) Äthylen-Vinyl-Acetate,
m) Polyvinyl-Alkohole,
n) Polyvinyl-Chloride,
o) Polystyrol,
p) Polymethyl-Methacrylate,
q) Anilin,
r) Wasser,
s) Mineralöl,
t) Agar,
u) Glycerin,
v) Polyvinyl-Butyryl,
w) Polybutyl-Methacrylat,
x) Cellulose,
y) Ölsäure,
z) Phthalat,
aa) Paraffin,
ab) Wachs, insbesondere Carnauba-Wachs,
ac) Ammonium,
ad) Polyacrylat,
ae) Diglycerid-Stearate und -Oleate,
af) Glyceryl-Monostearate,
ag) Isopropyl-Titanate,
ah) Lithium-Stearate,
ai) Monoglyceride,
aj) Formaldehyde,
ak) Octyl-Säure-Phosphate,
al) Olefin-Sulfonate,
am) Phosphat-Ester,
an) Stearinsäure,
ao) Zink-Stearate.

4. Herstellverfahren nach Anspruch 2 oder 3, **dadurch gekennzeichnet, dass** der Binder folgende Bestandteile enthält:
a) 10-50 Gewichtsprozent Polyamid,
b) 40-80 Gewichtsprozent Fettalkohol,
c) 2-20 Gewichtsprozent organische Säure.

5. Herstellverfahren nach einem der Ansprüche 2 bis 4, **dadurch gekennzeichnet, dass** der Binder folgende Bestandteile enthält:
a) 50 bis 96 Gewichtsprozent eines oder mehrerer Polyoxymethylen-Homopolymerisate oder Polyoxymethylen-Copolymerisate;
b) 2 bis 35 Gewichtsprozent eines oder mehrerer Polyolefine;
c) 2 bis 40 Gewichtsprozent Poly-1,3-dioxepan oder Poly-1,3-dioxolan oder deren Mischungen

6. Herstellungsverfahren nach einem der vorhergehenden Ansprüche, **dadurch gekennzeichnet, dass** die pulverförmige Widerstandslegierung als Hauptbestandteil Kupfer oder Nickel enthält.

7. Herstellungsverfahren nach einem der vorhergehenden Ansprüche, **dadurch gekennzeichnet, dass** die pulverförmige Widerstandslegierung folgende Legierungsbestandteile enthält:
a) 0,01-95,0 Gewichtsprozent Kupfer,
b) 0,01-80,0 Gewichtsprozent Nickel,
c) 0,01-30,0 Gewichtsprozent Mangan,
d) 0,001 -5,0 Gewichtsprozent Zinn,
e) 0,001-22,0 Gewichtsprozent Chrom,
f) 0,001-5,0 Gewichtsprozent Aluminium,
g) 0,001-2,0 Gewichtsprozent Silizium,
h) 0,001-1,5 Gewichtsprozent Eisen, und/oder
i) höchstens 1,0 Gewichtsprozent sonstige Legierungsbestandteile.

8. Herstellungsverfahren nach einem der Ansprüche 1 bis 6, **dadurch gekennzeichnet, dass** die pulverförmige Widerstandslegierung folgende Legierungsbestandteile enthält:
a) 50,0-55,0 Gewichtsprozent Kupfer,
b) 42,0-46,0 Gewichtsprozent Nickel,
c) 0,5-2,0 Gewichtsprozent Mangan, und
d) höchstens 1,5 Gewichtsprozent sonstige Legierungsbestandteile.

9. Herstellungsverfahren nach einem der Ansprüche 1 bis 6, **dadurch gekennzeichnet, dass** die pulverförmige Widerstandslegierung folgende Legierungsbestandteile enthält:
a) 81,0-89,6 Gewichtsprozent Kupfer,
b) 10,0-14,0 Gewichtsprozent Mangan,
c) 0,4-4,0 Gewichtsprozent Nickel, und
d) höchstens 1,0 Gewichtsprozent sonstige Legierungsbestandteile.

10. Herstellungsverfahren nach einem der Ansprüche 1 bis 6, **dadurch gekennzeichnet, dass** die pulverförmige Widerstandslegierung folgende Legierungsbestandteile enthält:
a) 60,0-69,0 Gewichtsprozent Kupfer,
b) 23,0-27,0 Gewichtsprozent Mangan,
c) 8,0-12,0 Gewichtsprozent Nickel, und
d) höchstens 1,0 Gewichtsprozent sonstige Legierungsbestandteile.

11. Herstellungsverfahren nach einem der Ansprüche 1 bis 6, **dadurch gekennzeichnet, dass** die pulverförmige Widerstandslegierung folgende Legierungsbestandteile enthält:
a) 88,0-92,5 Gewichtsprozent Kupfer,
b) 6,0-8,0 Gewichtsprozent Mangan,
c) 1,5-3,0 Gewichtsprozent Zinn, und
d) höchstens 1,0 Gewichtsprozent sonstige Legierungsbestandteile.

12. Herstellungsverfahren nach einem der Ansprüche 1 bis 6, **dadurch gekennzeichnet, dass** die pulverförmige Widerstandslegierung folgende Legierungsbestandteile enthält:
a) 62,0-81,4 Gewichtsprozent Nickel,
b) 16,0-22,0 Gewichtsprozent Chrom,
c) 2,0-4,0 Gewichtsprozent Aluminium,
d) 0,4-2,0 Gewichtsprozent Silizium,
e) 0,1-5,0 Gewichtsprozent Mangan,
f) 0,02-3,0 Gewichtsprozent Kupfer,
g) 0,1-1,0 Gewichtsprozent Eisen, und
h) höchstens 1,0 Gewichtsprozent sonstige Legierungsbestandteile.

13. Herstellungsverfahren nach einem der vorhergehenden Ansprüche,
**dadurch gekennzeichnet,**
a) **dass** das Widerstandselement (9; 17; 21; 25) einen elektrischen Widerstandswert mit einem Temperaturkoeffizienten von betragsmäßig weniger als 50ppm/K gemessen zwischen 20°C bis 60°C aufweist, und/oder
b) **dass** das Widerstandselement (9; 17; 21; 25) einen elektrischen Widerstandswert mit einer Langzeitdrift von weniger als 10% aufweist, insbesondere gemäß AEC-Q200, und/oder
c) **dass** die Widerstandslegierung einen spezifischen elektrischen Widerstand von weniger als, 20·10⁻⁷ Ωm, 10·10⁻⁷ Ωm, 5·10⁻⁷ Ωm oder 3·10⁻⁷ Ωm aufweist, und/oder
d) **dass** das Leitermaterial einen spezifischen elektrischen Widerstand von weniger als 5·10⁻⁷ Ωm, 2·10⁻⁷ Ωm, 1·10⁻⁷ Ωm, 5·10⁻⁸ Ωm oder 2·10⁻⁸ Ωm aufweist, und/oder
e) **dass** das Leitermaterial einen kleineren spezifischen elektrischen Widerstand aufweist als die Widerstandslegierung, und/oder
f) **dass** die Widerstandslegierung in der thermoelektrischen Spannungsreihe gegenüber Kupfer eine Thermospannung von weniger als ±5 mV/100 K, ±0,5 mV/100 K, ±0,3 mV/100 K oder ±0,2 mV/100 K aufweist.

14. Herstellungsverfahren nach einem der vorhergehenden Ansprüche, **gekennzeichnet durch** folgenden Schritt:
Anformen von Kühlkörpern (28-31), insbesondere Kühlrippen (28-31), an das Widerstandselement (9; 17; 21; 25).

15. Widerstand (14; 18; 22), insbesondere Strommesswiderstand (14; 18; 22), mit
a) einem ersten Anschlussteil (15; 19; 23) aus einem elektrisch leitfähigen Leitermaterial zum Einleiten eines elektrischen Stroms in den Widerstand,
b) einem zweiten Anschlussteil (16; 20; 24) aus dem elektrisch leitfähigen Leitermaterial zum Ausleiten des elektrischen Stroms aus dem Widerstand, und
c) einem Widerstandselement (17; 21; 25) aus einer Widerstandslegierung, das in Stromflussrichtung zwischen den beiden Anschlussteilen (15, 16; 19, 20; 23, 24) angeordnet ist und von dem elektrischen Strom durchflossen wird,
**dadurch gekennzeichnet,**
d) **dass** der Widerstand (14; 18; 22) mittels des Herstellungsverfahrens nach einem der vorhergehenden Ansprüche hergestellt ist.

## Claims

1. Method of manufacturing an electrical resistor (14; 18; 22) with an electrical resistor element (9; 17; 21; 25) and several connection parts (15, 16; 19, 20; 23, 24; 26, 27), in particular for a current sense resistor, with the following steps:
a) providing a resistance alloy in powder form, and
b) forming the resistor element (9; 17; 21; 25) from the powdery resistance alloy,
**characterized in**
c) **that** a multi-component metal powder injection molding is used for forming the resistor element (9; 17; 21; 25), wherein the following components of the resistor (14; 18; 22) are joined together to form a green part:
c1) the resistor element (9; 17; 21; 25) which is made of the powdery resistance alloy, and
c2) the connection parts (15, 16; 19, 20; 23, 24, 26, 27) made of a powdery conductor material, in particular of copper or a copper alloy.

2. Method of manufacturing according to claim 1, **characterized by** the following steps:
a) mixing the powdery resistance alloy and the powdery conductor material with a binder to each form a feedstock before moulding, in particular with an organic binder, in particular with a mixture of further, in particular organic, components, the feedstock of the resistance alloy preferably containing the following constituents:
a1) 50-80 weight percent of the resistance alloy and
a2) 20-50 weight percent of the organic components, and
b) debinding the green part to a brown part after moulding, whereby the binder is at least partially removed from the green part, and
c) sintering the brown part to the finished resistor (14; 18; 19), and
d) reworking of the resistor element (9; 17; 21; 25), in particular correction of the resistance value by milling or punching.

3. Method of manufacturing according to claim 2, **characterized in that** the binder contains at least one of the following materials:
a) polyamide,
b) polyoxymethylene,
c) polycarbonate,
d) styrene-acrylonitrile copolymer,
e) polyimide,
f) natural wax and oil,
g) thermoset,
h) cyanates,
i) polypropylene,
j) polyacetates,
k) polyethylenes,
l) ethylene vinyl acetates,
m) polyvinyl alcohols,
n) polyvinyl chlorides,
o) polystyrene,
p) polymethyl methacrylates,
q) aniline,
r) water,
s) mineral oil,
t) agar,
u) glycerol,
v) polyvinyl butyryl,
w) polybutyl methacrylate,
x) cellulose,
y) oleic acid,
z) phthalate,
aa) kerosene wax,
ab) wax, especially carnauba wax,
ac) ammonium,
ad) polyacrylate,
ae) diglyceride stearates and oleates,
af) glyceryl monostearates,
ag) isopropyl titanates,
ah) lithium stearates,
ai) monoglycerides,
aj) formaldehydes,
ak) octyl acid phosphates,
al) olefin sulphonates,
am) phosphate ester,
an) stearic acid,
ao) zinc stearates.

4. Method of manufacturing according to claim 2 or 3, **characterized in that** the binder contains the following components:
a) 10-50 weight percent polyamide,
b) 40-80 weight percent of fatty alcohol,
c) 2-20 weight percent of organic acid.

5. Method of manufacturing according to any of claims 2 to 4, **characterized in that** the binder contains the following components:
a) 50 to 96 weight percent of one or more polyoxymethylene homopolymers or polyoxymethylene copolymers;
b) 2 to 35 weight percent of one or more polyolefins;
c) 2 to 40 weight percent of poly-1,3-dioxepan or poly-1,3-dioxolane or mixtures thereof

6. Method of manufacturing according to any of the preceding claims, **characterized in that** the powdery resistance alloy contains copper or nickel as the main component.

7. Method of manufacturing according to one of the preceding claims, **characterized in that** the powdery resistance alloy contains the following alloy components:
a) 0.01-95.0 weight percent copper,
b) 0.01-80.0 weight percent nickel,
c) 0.01-30.0 weight percent manganese,
d) 0.001 -5.0 weight percent tin,
e) 0.001-22.0 weight percent chromium,
f) 0.001-5.0 weight percent aluminum,
g) 0.001-2.0 weight percent silicon,
h) 0,001-1.5 weight percent of iron; and/or
i) not more than 1.0 weight percent of other alloying elements.

8. Method of manufacturing according to one of claims 1 to 6, **characterized in that** the powdery resistance alloy contains the following alloying constituents:
a) 50.0-55.0 weight percent copper,
b) 42.0-46.0 weight percent nickel,
c) 0.5-2.0 weight percent manganese, and
d) not more than 1.5 weight percent of other alloying elements.

9. Method of manufacturing according to one of claims 1 to 6, **characterized in that** the powdery resistance alloy contains the following alloying constituents:
a) 81.0-89.6 weight percent copper,
b) 10.0-14.0 weight percent manganese,
c) 0.4-4.0 weight percent nickel; and
d) not more than 1.0 weight percent of other alloying elements.

10. Method of manufacturing according to one of claims 1 to 6, **characterized in that** the powdery resistance alloy contains the following alloying constituents:
a) 60.0-69.0 weight percent copper,
b) 23.0-27.0 weight percent manganese,
c) 8.0-12.0 weight percent nickel; and
d) not more than 1.0 weight percent of other alloying elements.

11. Method of manufacturing according to any of claims 1 to 6, **characterized in that** the powdery resistance alloy contains the following alloying elements:
a) 88.0-92.5 weight percent copper,
b) 6.0-8.0 weight percent manganese,
c) 1.5-3.0 weight percent tin, and
d) not more than 1.0 weight percent of other alloying elements.

12. Method of manufacturing according to one of claims 1 to 6, **characterized in that** the powdery resistance alloy contains the following alloying constituents:
a) 62.0-81.4 weight percent nickel,
b) 16.0-22.0 weight percent chrome,
c) 2.0-4.0 weight percent aluminum,
d) 0.4-2.0 weight percent silicon,
e) 0.1-5.0 weight percent manganese,
f) 0.02-3.0 weight percent copper,
g) 0.1-1.0 weight percent iron; and
h) not more than 1.0 weight percent of other alloying elements.

13. Method of manufacturing according to any of the above claims, **characterized in**
a) **that** the resistor element (9; 17; 21; 25) has an electrical resistance value with a temperature coefficient of less than 50 ppm/K measured between 20 °C and 60 °C, and/or
b) **that** the resistor element (9; 17; 21; 25) has an electrical resistance value with a long-term drift of less than 10%, in particular according to AEC-Q200, and/or
c) **that** the resistive alloy has a specific electrical resistance of less than 20·10⁻⁷ Ωm, 10·10⁻⁷ Ωm, 5·10⁻⁷ Ωm or 3·10⁻⁷ Ωm; and/or
d) **that** the conductor material has a specific electrical resistance of less than 5·10⁻⁷ Ωm, 2·10⁻⁷ Ωm, 1·10⁻⁷ Ωm, 5·10⁻⁸ Ωm or 2·10⁻⁸ Ωm, and/or
e) **that** the conductor material has a lower specific electrical resistance than the resistance alloy, and/or
f) **that** the resistive alloy has a thermoelectric emf with respect to copper in the thermoelectric series of voltages of less than ±5 mV/100 K, ±0.5 mV/100 K, ±0.3 mV/100 K or ±0.2 mV/100 K.

14. Method of manufacturing according to any of the preceding claims, **characterized by** the following step:
Moulding heat sinks (28-31), in particular cooling fins (28-31), onto the resistor element (9; 17; 21; 25).

15. Resistor (14; 18; 22), in particular current sense resistor (14; 18; 22), with
a) a first connection part (15; 19; 23) made of an electrically conductive conductor material for introducing an electric current into the resistor,
b) a second connection part (16; 20; 24) made of the electrically conductive conductor material for diverting the electric current from the resistor, and
c) the resistor element (17; 21; 25) made of a powdery resistance alloy, which is arranged in the direction of current flow between the two connection parts (15, 16; 19, 20; 23, 24) and through which the electric current flows,
**characterized in**
d) **that** the resistor (14; 18; 22) is manufactured by the method of manufacturing according to one of the preceding claims.

## Revendications

1. Procédé de fabrication pour une résistance électrique (14; 18; 22) avec un élément de résistance (9; 17; 21; 25) électrique et plusieurs pièces de raccordement (15, 16; 19, 20; 23, 24, 26, 27), en particulier pour une résistance de mesure de courant, avec les étapes suivantes:
a) la fourniture d'un alliage de résistance sous forme de poudre, et
b) le façonnage de l'élément de résistance (9; 17; 21; 25) à partir de l'alliage de résistance pulvérulent,
**caractérisé en ce**
c) **qu'**un moulage par injection de poudre métallique multicomposant est utilisé pour façonner l'élément de résistance (9; 17; 21; 25), dans lequel les composants suivants de la résistance (14; 18; 22) sont assemblés en une pièce verte:
c1) l'élément de résistance (9; 17; 21; 25) composé de l'alliage de résistance pulvérulent, et
c2) les pièces de raccordement (15, 16; 19, 20; 23, 24, 26, 27) composées d'un matériau conducteur pulvérulent, en particulier de cuivre ou d'un alliage de cuivre.

2. Procédé de fabrication selon la revendication 1, **caractérisé par** les étapes suivantes:
a) le mélange de l'alliage de résistance pulvérulent et du matériau conducteur pulvérulent avec un liant en respectivement un mélange-maître avant le façonnage, en particulier avec un liant organique, en particulier avec un mélange d'autres composants, en particulier organiques, dans lequel le mélange-maître de l'alliage de résistance contient de préférence les constituants suivants:
a1) 50-80 % en poids de l'alliage de résistance et
a2) 20-50 % en poids des composants organiques, et
b) le déliantage de la pièce verte en une pièce brune après le façonnage, dans lequel le liant est retiré au moins partiellement de la pièce verte, et
c) le frittage de la pièce brune en la résistance (14; 18; 22) finie, et
d) le post-usinage de l'élément de résistance (9; 17; 21; 25) en particulier la correction de la valeur de résistance par fraisage ou poinçonnage.

3. Procédé de fabrication selon la revendication 2, **caractérisé en ce que** le liant contient au moins l'un des matériaux suivants:
a) polyamide,
b) polyoxyméthylène,
c) polycarbonate,
d) copolymère styrène-acrylonitrile,
e) polyimide,
f) cire naturelle et huile,
g) résine thermodurcissable,
h) cyanates,
i) polypropylènes,
j) polyacétates,
k) polyéthylènes,
i) acétates d'éthylène-vinyle,
m) alcools polyvinyliques,
n) polychlorure de vinyle,
o) polystyrène,
p) polyméthacrylates de méthyle,
q) aniline,
r) eau,
s) huile minérale,
t) gélose,
u) glycérine,
v) polyvinyle-butyryle,
w) méthacrylate de polybutyle,
x) cellulose,
y) acide oléique,
z) phtalate,
aa) paraffine,
ab) cire, en particulier cire de carnauba,
ac) ammonium,
ad) polyacrylate,
ae) stéarates et oléates de diglycéride,
af) monostéarates de glycéryle,
ag) titanates d'isopropyle,
ah) stéarates de lithium,
ai) monoglycérides,
aj) formaldéhydes,
ak) phosphates d'acide octylique,
al) sulfonates d'oléfine,
am) ester de phosphate,
an) acide stéarique,
ao) stéarates de zinc.

4. Procédé de fabrication selon la revendication 2 ou 3, **caractérisé en ce que** le liant contient les constituants suivants:
a) 10-50 % en poids de polyamide,
b) 40-80 % en poids d'alcool gras,
c) 2-20 % en poids d'acide organique.

5. Procédé de fabrication selon l'une quelconque des revendications 2 à 4, **caractérisé en ce que** le liant contient les constituants suivants:
a) 50 à 96 % en poids d'un ou plusieurs homopolymères de polyoxyméthylène ou copolymères de polyoxyméthylène;
b) 2 à 35 % en poids d'une ou plusieurs polyoléfines;
c) 2 à 40 % en poids de poly-1,3-dioxépane ou de poly-1,3-dioxolane ou leurs mélanges

6. Procédé de fabrication selon l'une quelconque des revendications précédentes, **caractérisé en ce que** l'alliage de résistance pulvérulent contient comme constituant principal du cuivre ou du nickel.

7. Procédé de fabrication selon l'une quelconque des revendications précédentes, **caractérisé en ce que** l'alliage de résistance pulvérulent contient les constituants d'alliage suivants:
a) 0,01-95,0 % en poids de cuivre,
b) 0,01-80,0 % en poids de nickel,
c) 0,01-30,0 % en poids de manganèse,
d) 0,001-5,0 % en poids d'étain,
e) 0,001-22,0 % en poids de chrome,
f) 0,001-5,0 % en poids d'aluminium,
g) 0,001-2,0 % en poids de silicium,
h) 0,001-1,5 % en poids de fer, et/ou
i) 1,0 % en poids maximum d'autres constituants d'alliage.

8. Procédé de fabrication selon l'une quelconque des revendications 1 à 6, **caractérisé en ce que** l'alliage de résistance pulvérulent contient les constituants d'alliage suivants:
a) 50,0-55,0 % en poids de cuivre,
b) 42,0-46,0 % en poids de nickel,
c) 0,5-2,0 % en poids de manganèse, et
d) 1,5 % en poids maximum d'autres constituants d'alliage.

9. Procédé de fabrication selon l'une quelconque des revendications 1 à 6, **caractérisé en ce que** l'alliage de résistance pulvérulent contient les constituants d'alliage suivants:
a) 81,0-89,6 % en poids de cuivre,
b) 10,0-14,0 % en poids de manganèse,
c) 0,4-4,0 % en poids de nickel, et
d) 1,0 % en poids maximum d'autres constituants d'alliage.

10. Procédé de fabrication selon l'une quelconque des revendications 1 à 6, **caractérisé en ce que** l'alliage de résistance pulvérulent contient les constituants d'alliage suivants:
a) 60,0-69,0 % en poids de cuivre,
b) 23,0-27,0 % en poids de manganèse,
c) 8,0-12,0 % en poids de nickel, et
d) 1,0 % en poids maximum d'autres constituants d'alliage.

11. Procédé de fabrication selon l'une quelconque des revendications 1 à 6, **caractérisé en ce que** l'alliage de résistance pulvérulent contient les constituants d'alliage suivants:
a) 88,0-92,5 % en poids de cuivre,
b) 6,0-8,0 % en poids de manganèse,
c) 1,5-3,0 % en poids d'étain, et
d) 1,0 % en poids maximum d'autres constituants d'alliage.

12. Procédé de fabrication selon l'une quelconque des revendications 1 à 6, **caractérisé en ce que** l'alliage de résistance pulvérulent contient les constituants d'alliage suivants:
a) 62,0-81,4 % en poids de nickel,
b) 16,0-22,0 % en poids de chrome,
c) 2,0-4,0 % en poids d'aluminium,
d) 0,4-2,0 % en poids de silicium,
e) 0,1-5,0 % en poids de manganèse,
f) 0,02-3,0 % en poids de cuivre,
g) 0,1-1,0 % en poids de fer, et
h) 1,0 % en poids maximum d'autres constituants d'alliage.

13. Procédé de fabrication selon l'une quelconque des revendications précédentes, **caractérisé en ce**
a) **que** l'élément de résistance (9; 17; 21; 25) présente une valeur de résistance électrique avec un coefficient de température de moins de 50 ppm/K en termes de valeur mesuré entre 20 °C et 60 °C, et/ou
b) **que** l'élément de résistance (9; 17; 21; 25) présente une valeur de résistance électrique avec une dérive à long terme inférieure à 10 %, en particulier selon AEC-Q200, et/ou
c) **que** l'alliage de résistance présente une résistance électrique spécifique inférieure à, 20·10⁻⁷ Ωm, 10·10⁻⁷ Ωm, 5·10⁻⁷ Ωm ou 3·10⁻⁷ Ωm, et/ou
d) **que** le matériau conducteur présente une résistance électrique spécifique inférieure à 5·10⁻⁷ Ωm, 2·10⁻⁷ Ωm, 1·10⁻⁷ Ωm, 5·10⁻⁸ Ωm ou 2·10⁻⁸ Ωm, et/ou
e) **que** le matériau conducteur présente une résistance électrique spécifique inférieure à l'alliage de résistance, et/ou
f) **que** l'alliage de résistance présente dans la plage de tensions thermoélectriques par rapport au cuivre une tension thermique inférieure à ±5 mV/100 K, ±0,5 mV/100 K, ±0,3 mV/100 K ou ±0,2 mV/100 K.

14. Procédé de fabrication selon l'une quelconque des revendications précédentes, **caractérisé par** l'étape suivante:
le formage de dissipateurs thermiques (28-31), en particulier d'ailettes de refroidissement (28-31), sur l'élément de résistance (9; 17; 21; 25).

15. Résistance (14; 18; 22), en particulier résistance de mesure de courant (14; 18; 22), avec
a) une première pièce de raccordement (15; 19; 23) composée d'un matériau conducteur électriquement conducteur pour introduire un courant électrique dans la résistance,
b) une seconde pièce de raccordement (16; 20; 24) composée du matériau conducteur électriquement conducteur pour évacuer le courant électrique de la résistance, et
c) un élément de résistance (17; 21; 25) composé d'un alliage de résistance qui est disposé dans le sens du flux de courant entre les deux pièces de raccordement (15, 16; 19, 20; 23, 24) et est traversé par le courant électrique,
**caractérisé en ce**
d) **que** la résistance (14; 18; 22) est fabriquée au moyen du procédé de fabrication selon l'une quelconque des revendications précédentes.
